# EUROPÄISCHE PATENTSCHRIFT

(11) **EP 1 130 782 B1**
(45) Veröffentlichungstag und Bekanntmachung des Hinweises auf die Patenterteilung: **31.07.2013**
(21) Anmeldenummer: 01109089.1
(22) Anmeldetag: 14.06.1995
(51) Int. Cl.: H03M 1/10, H03M 1/18

(54) **Verfahren und Anordnung zur Analog-Digital-Wandlung von Signalen**
Method and circuit for the analogue-to-digital conversion of signals
Procédé et circuit de conversion analogique-numérique de signaux

(30) Priorität: 12.01.1995 DE 19502047
(43) Veröffentlichungstag der Anmeldung: 05.09.2001
(62) Teilanmeldung aus: 95250144.3
(73) Patentinhaber: Stage Tec Entwicklungsgesellschaft für professionelle Audiotechnik mbH, 12459 Berlin (DE)
(72) Erfinder: Jahne, Helmut, Dr., 10409 Berlin (DE); Cain, Klaus, 12524 Berlin (DE); Altenberg, Olaf, DE-12437 Berlin (DE); Kutschabsky, Detlef, DE-12524 Berlin (DE)
(74) Vertreter: Obst, Bernhard

(56) Entgegenhaltungen:
- EP-A- 0 346 605
- US-A- 4 999 628

## Beschreibung

Die Erfindung bezieht sich auf ein Verfahren zur Analog-Digital-Wandlung von Signalen und auf eine Anordnung zur Durchführung des Verfahrens, wobei das Anwendungsgebiet der Erfindung in der Sensortechnik, der Messtechnik, der Audiotechnik und auch im weiten Bereich der applikationsspezifischen Mikroprozessoranwendung liegt.

Es ist bekannt, dass Analogsignale mit einer großen Dynamik, also solche mit kleinen und großen Werten, insbesondere hinsichtlich der kleinen Werte nur ungenau zu digitalisieren sind. Dies führt zu größeren Rechenfehlern bei weiterer digitaler Verarbeitung bzw. zu einem Ansteigen des Klirrfaktors bei kleiner werdenden Signalen. Aus diesem Grund finden in den oben genannten Fällen AD-Wandler mit einer hohen Auflösung Anwendung, obwohl die damit erzielbare genauere Digitalisierung großer Werte oftmals nicht benötigt wird und zudem hochauflösende AD-Wandler erheblich teurer sind. Einigen Anwendungen blieb die digitale Verarbeitung bisher ganz verschlossen, da derartig hochauflösende Wandler bei entsprechender Wandlungsrate bislang nicht verfügbar waren. Stellvertretend sei hier das Studiomikrofon für den professionellen Einsatz mit integriertem AD-Wandler genannt.

In allen diesen Bereichen versucht man seit langem kostengünstige, weniger hochauflösende Wandler mit schaltbarer Vorverstärkung auszustatten.

In der DE-OS 4312697 wird das Problem eines hochauflösenden AD-Wandlers mit zwei weniger hochauflösenden AD-Wandlern und einem hochauflösenden DA-Wandler gelöst. Das Problem wird also nur auf die DA-Wandler verlagert.

In der DE-OS 3603833 wird ein steuerbarer Verstärker (VCA) verwendet, um einen weniger hochauflösenden AD-Wandler stets im optimalen Arbeitsbereich zu halten. Mit einem zweiten, weniger hochauflösenden AD-Wandler wird die Steuerspannung des VCA digitalisiert und einem Exponenten entsprechend mit dem Digitalsignal des ersten AD-Wandlers verknüpft. Problematisch ist zum einen die nichtlineare Steuerkennlinie eines jeden VCA und zum zweiten der VCA selbst. Die besten heute erhältlichen VCA's weisen ein höheres Grundrauschen und wesentlich größere Signalverzerrungen als gute AD-Wandler auf.

Ein prinzipiell anderer Weg wird mit der DE-OS 2946502 gegangen. Hier wird ein hochauflösender AD-Wandler für seismische Signale beschrieben, der mit einem weniger hochauflösenden AD-Wandler und mit mehreren Vorverstärkern mit fester und bekannter Vorverstärkung aufgebaut ist. Je nach Größe des zu digitalisierenden Signals wird der AD-Wandler mit dem geeigneten Vorverstärker verbunden, und das Digitalsignal durch Division mit dem Vorverstärkungsfaktor gewonnen. Das gleiche Verfahren beschreibt auch die DE-OS 3816903.

Die EP0346605 betrifft einen hochauflösenden A/D-Umsetzer, dem ein Verstärker mit in L + 1-Stufen programmierter Verstärkung vorgeschaltet ist und dem durch Auswahl der Verstärkungsstufe das ohne Übersteuerung größtmögliche Signal zur Umsetzung zugeführt wird. Ziel der EP0346605 ist es, eine höhere Auflösung zu erreichen, als diejenige, die an sich aufgrund der Bitanzahl gegeben ist. Das Ziel wird erreicht, indem das analoge Eingangssignal um einen bestimmten Faktor sₗ verstärkt und anschließend in ein digitales Wort umgesetzt wird; danach wird dieses umgesetzte Wort multipliziert mit dem Kehrwert 1/sₗ des Faktors, wobei die Wortlänge vergrößert wird. Anwendungsgebiet ist die Audiosignalverarbeitung in Tonstudios.

Aus der US 4,999,628 ist eine Analog-Digital-Wandlereinheit (AD-Wandlereinheit) bekannt, wobei die AD-Wandlereinheit umfasst: einen Analogpegeländerungsschaltkreis, der eine Vielzahl von Verstärkungen aufweist und eine Größe eines analogen Eingangssignals variiert, um eine Vielzahl von analogen Ausgangssignalen zu erzeugen, die sich hinsichtlich ihrer Größe voneinander entsprechend der Verstärkungen unterscheiden, eine Vielzahl von Analog-Digital-Wandlerschaltkreisen, die entsprechend der analogen Ausgangssignale vorgesehen sind und entsprechend eine Vielzahl von digital codierten Signalen erzeugen, einen Steuerschaltkreis, der mit zwei digital codierten Signalen versorgt wird und eine Differenz zwischen diesen berechnet, um ein erstes Steuersignal zu erzeugen, welches anzeigt, eines der digital codierten Signale in einen Wert zu ändern, sodass dieser gleich dem Wert des anderen digital codierten Signals ist, einen Berechnungsschaltkreis, der als Antwort auf das erste Steuersignal wirkt und verursacht, dass eines der digital codierten Signale in seinem Wert verändert wird, um einen Kandidaten für ein digitales Ausgangssignal zu erzeugen, und einen Ausgangsschaltkreis, der mit einem der Analog-Digital-Konverterschaltkreise und dem Berechnungsschaltkreis verbunden ist und das Ausgangssignal an einem Ausgangsknoten zur Verfügung stellt. Da der Wert des analogen Eingangssignals aus dem digital codierten Signal auf Basis der Differenz abgeleitet wird, soll die Analog-Digital-Einheit unabhängig von Änderungen in der Umgebung sein.

Der Erfindung liegt die Aufgabe zugrunde, ein verbessertes Verfahren und eine verbesserte Anordnung für hochauflösende Analog-Digital-Wandlung unter Verwendung weniger hochauflösender AD-Wandler zu schaffen.

Die Aufgabe wird erfindungsgemäß durch ein Verfahren und eine Anordnung mit den Merkmalen des Patentanspruchs 1 sowie ein Verfahren und eine Anordnung mit den Merkmalen des Patenanspruchs 3 geschaffen.

Vorgeschlagen werden ein Verfahren und eine Anordnung zur Analog-Digital-Wandlung von Signalen unter Verwendung mindestens zweier weniger hochauflösender AD-Wandler, dadurch gekennzeichnet, dass das analoge Signal einmal unverstärkt zu einem ersten Digitalsignal (x1) und zum anderen nach einer Signalverarbeitung, im allgemeinen einer fehlerbehafteten Verstärkung größer eins, deren Größe nicht genau bekannt sein muss, zu einem zweiten Digitalsignal (x2) umgewandelt wird, wobei in dem Fall, dass
a) der Wert des zweiten Digitalsignals (x2) sich mit großer Wahrscheinlichkeit in einem Bereich befindet, in dem er durch Übersteuerung hervorgerufen wurde, zweckmäßigerweise durch Überschreitung einer ersten Schranke (s1) des Betrages des ersten Digitalsignals (x1) ermittelt (ABS(x1)>s1), sich das digitale Ausgangssignal (y) aus dem ersten Digitalsignal (x1) ergibt (y=x1), und dass im anderen Fall
b) sich das digitale Ausgangssignal (y) entweder aus einer Multiplikation des zweiten digitalen Signals (x2) mit der angenommenen inversen Verstärkung (a) und einer Addition mit einem bekannten negativen Offset (b) ergibt (y=a*x2+b), und weiterhin, dass in diesem Falle die angenommene inverse Verstärkung durch rekursive Berechnung aktualisiert wird, oder aus einer Multiplikation des zweiten digitalen Signals (x2) mit der angenommenen inversen Verstärkung (a) und der Addition mit dem negativen angenommenen Offset (b) ergibt (y=a*x2+b), und weiterhin, dass in diesem Falle die angenommene inverse Verstärkung und der angenommene negative Offset durch rekursive Berechnung aktualisiert werden.

Es wird ein bekannter negativer Offset oder ein angenommener negativer Offset in die Berechnung des digitalen Ausgangssignals (y) einbezogen, und zwar immer dann, wenn die Aussage nicht zutrifft, dass der Wert des zweiten Digitalsignals (x2) sich mit großer Wahrscheinlichkeit in einem Bereich befindet, in dem er durch Übersteuerung hervorgerufen wurde.

Insbesondere werden gemäß einer ersten Ausgestaltung ein Verfahren und Anordnung zur Analog-Digital-Wandlung von Signalen unter Verwendung mindestens zweier weniger hochauflösender AD-Wandler vorgeschlagen, wobei das analoge Signal einmal unverstärkt zu einem ersten Digitalsignal (x1) und zum anderen nach einer Signalverarbeitung, im allgemeinen einer fehlerbehafteten Verstärkung größer eins, deren Größe nicht genau bekannt sein muss, zu einem zweiten Digitalsignal (x2) umgewandelt wird, wobei in dem Fall, dass
a) der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), sich das digitale Ausgangssignal (y) aus dem ersten Digitalsignal (x1) ergibt (y=x1), und dass im anderen Fall
b) sich das digitale Ausgangssignal (y) aus einer Multiplikation des zweiten Digitalsignals (x2) mit der angenommenen inversen Verstärkung (a) und einer Addition mit einem negativen bekannten Offset (b) ergibt (y=a*x2+b), und weiterhin, dass in diesem Falle die angenommene inverse Verstärkung durch rekursive Berechnung aktualisiert wird.

Eine Weiterbildung sieht vor, dass die rekursive Berechnung der inversen Verstärkung nach der Formel: a:=a+(((x1+a*x2-b)/2/x2)-a)*d erfolgt, wobei b den bekannten Offset darstellt und d eine sehr kleine Zahl darstellt, beispielsweise 0,001, welche die Rekursionsgeschwindigkeit festlegt.

Ferner werden gemäß einer zweiten Ausgestaltung ein Verfahren und eine Anordnung zur Analog-Digital-Wandlung von Signalen unter Verwendung mindestens zweier weniger hochauflösender AD-Wandler vorgeschlagen, wobei das analoge Signal einmal unverstärkt zu einem ersten Digitalsignal (x1) und zum anderen nach einer Signalverarbeitung, im allgemeinen einer fehlerbehafteten Verstärkung größer eins, deren Größe nicht genau bekannt sein muss, zu einem zweiten Digitalsignal (x2) umgewandelt wird, wobei in dem Fall, dass
a) der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), sich das digitale Ausgangssignal (y) aus dem ersten Digitalsignal (x1) ergibt (y=x1), und dass im anderen Fall
b) sich das digitale Ausgangssignal (y) aus einer Multiplikation des zweiten digitalen Signals (x2) mit der angenommenen inversen Verstärkung (a) und der Addition mit dem negativen angenommenen Offset (b) ergibt (y=a*x2+b), und weiterhin, dass in diesem Falle die angenommene inverse Verstärkung und der angenommene negative Offset durch rekursive Berechnung aktualisiert werden.

Eine Weiterbildung gemäß der zweiten Ausgestaltung sieht vor, dass zusätzlich falls der Wert des ersten Digitalsignals (x1) sich in einem Bereich befindet, in dem der Betrag des ersten Signals (s1) eine erste Schranke (s1) unterschreitet jedoch eine zweite, kleinere Schranke (s2) überschreitet (s1>ABS(x1)>s2), die angenommene inverse Verstärkung und der angenommene negative Offset durch rekursive Berechnung aktualisiert werden; denn bei Unterschreitung der zweiten Schwelle (s2) ist die Auflösung des ersten Digitalsignals (x1) derart gering, dass eine rekursive Berechnung nur mit großen Fehlern erfolgen könnte.

Gemäß einigen Ausführungsformen der zweiten Ausgestaltung ist vorgesehen, dass in dem Fall,
a) dass der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), sich das digitale Ausgangssignal (y) aus dem ersten Digitalsignal (x1) ergibt (y=x1),
b) dass der Wert des ersten Digitalsignals (x1) sich in einem Bereich befindet, in dem der Betrag des ersten Digitalsignals (x1) die ersten Schranke (s1) unterschreitet und außerdem eine zweite, kleinere Schranke (s2) unterschreitet (ABS(x1)<s2), sich das digitale Ausgangssignal (y) aus einer Multiplikation des zweiten Digitalsignals (x2) mit der angenommenen inversen Verstärkung (a) und der Addition mit dem negativen angenommenen Offset (b) ergibt (y=a*x2+b), und
c) dass, falls keiner der ersten beiden Fälle zutrifft, also der Wert des ersten Digitalsignals (x1) sich in einem Bereich befindet, in dem der Betrag des ersten Signals (s1) eine ersten Schranke (s1) unterschreitet jedoch eine zweite, kleinere Schranke (s2) überschreitet (s1>ABS(x1)>s2), eine Gewichtsfunktion gebildet wird, die ein Überblenden zwischen beiden in den ersten Fällen beschriebenen Berechnungsvorschriften gestattet, in der Weise, dass das digitale Ausgangssignal (y) gebildet wird aus der Summe des mit dem Gewicht (g) multiplizierten ersten Digitalsignals(x1) und der mit dem inversen Gewicht (1-g) multiplizierten Summe - aus dem negativen angenommenen Offset (b) und der Multiplikation des zweiten Digitalsignals (x2) mit der angenommenen inversen Verstärkung (a),(y=g*x1+(1-g)*(a*x2+b)) und außerdem die angenommene inverse Verstärkung und der angenommene negative Offset durch rekursive Berechnung aktualisiert werden.

Bei einigen Weiterbildungen der Ausführungsformen gemäß der zweiten Ausgestaltung ist vorgesehen, dass das Gewicht (g) eine lineare Funktion ist und gleich dem Quotienten aus der Differenz zwischen dem Betrag des ersten Digitalsignals (x1) und der zweiten Schwelle (s2) geteilt durch die Differenz zwischen der ersten Schwelle (s1) und der zweiten Schwelle (s2) ist (g=(ABS(x1)-S2)/(s1-s2)).

Ferner werden Ausführungsformen gemäß der ersten und zweiten Ausgestaltung vorgeschlagen, bei denen in dem Fall, dass der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), und auch in dem Fall, dass die Zeit seit der letzten Überschreitung des Betrages des ersten Digitalsignals (x1) über die erste Schranke (s1) (ABS(x1)>s1) kleiner als eine vorgegebene Zeit (t) ist, sich das digitale Ausgangssignal (y) aus dem ersten Digitalsignal (x1) ergibt, wobei in den anderen Fällen wie zuvor beschrieben verfahren wird.

Bei Weiterbildungen der Ausführungsformen gemäß beider Ausgestaltungen kann vorgesehen sein, dass bei periodischen Abtastungen des Signals die Anzahl der Perioden nach Überschreitung des Betrages des ersten Digitalsignals (x1) über die erste Schranke (s1) gezählt werden, um ein Mass für die Zeit (t) zu erhalten.

Bei einigen Weiterbildungen gemäß der zweiten Ausgestaltung ist vorgesehen, dass die rekursive Berechnung der inversen Verstärkung und des negativen Offsets nur bei langsamen Signaländerungen erfolgt, ermittelt aus der Unterschreitung der Differenz aus dem letzten und dem aktuellen Wert des ersten Digitalsignals (x1) oder des zweiten Digitalsignals (x2) unter den Wert einer differenziellen Schranke (s3), wodurch ein Fehler, hervorgerufen durch eine Signallaufzeitdifferenz des zweiten Digitalsignals (x2) in der Signalverarbeitungsstufe gegenüber dem ersten digitalen Digitalsignal (x1), minimiert werden kann.

Bei anderen Weiterbildungen gemäß der zweiten Ausgestaltung kann vorgesehen sein, dass bei Überschreitung der differenziellen Schranke (s3) eine rekursive Berechnung der Laufzeitdifferenz erfolgt, dass ein drittes Digitalsignal (x3) berechnet wird, welches dem zweiten Digitalsignal (x2) verzögert um die berechnete Laufzeit entspricht, und dass das dritte Digitalsignal (x3) an Stelle des zweiten Digitalsignals (x2) in den Gleichungen zur Berechnung des digitalen Ausgangssignals (y) verwendet wird.

Bei wieder anderen Weiterbildungen gemäß der zweiten Ausgestaltung kann vorgesehen sein, dass bei Überschreitung der differenziellen Schranke (s3) eine rekursive Berechnung der Laufzeitdifferenz basierend auf einer Tiefpasslaufzeit erfolgt, dass ein drittes Digitalsignal (x3) berechnet wird, welches dem zweiten Digitalsignal (x2) gefiltert mit dem berechneten Tiefpass entspricht, und dass das dritte Digitalsignal (x3) an Stelle des zweiten Digitalsignals (x2) in den Gleichungen zur Berechnung des digitalen Ausgangssignals (y) verwendet wird.

Bei einigen Ausführungsformen beider Ausgestaltungen ist vorgesehen, dass im Falle unipolarer analoger Signale die Betragsbildung des ersten Digitalsignals (x1) beim Vergleich mit der ersten Schranke (s1) entfallen kann.

Bei einigen Weiterbildungen der zweiten Ausführungsform ist vorgesehen, dass die rekursive Berechnung der inversen Verstärkung nach der Berechnungsvorschrift: a:=a+(((x1+a*x2-b)/2/x2)-a)*d erfolgt, wobei d eine sehr kleine Zahl darstellt, beispielsweise 0,001, welche die Rekursionsgeschwindigkeit festlegt, und dass der angenommene negative Offset durch rekursive Berechnung aktualisiert wird nach der Berechnungsvorschrift: b:=b+(((x1-a*x2+b)/2)-b)*d, wobei d, ohne Beschränkung der Allgemeinheit, gleich dem oben aufgeführten Wert d ist.

Bei einigen Ausführungsformen der zweiten Ausgestaltung ist vorgesehen, dass bei bipolaren Signalen die rekursive Berechnung der inversen Verstärkung und des negativen Offsets auf einer positiven Hilfsgröße (p) und einer negativen Hilfsgröße (n) beruhen, wobei die positive Hilfsgröße (p) an der positiven Stützstelle (xp) berechnet wird und die negative Hilfsgröße (n) an der negativen Stützstelle (xn) berechnet wird, und wobei die Werte der positiven Stützstelle nahe oder gleich dem positiven Fullscalewert des zweiten Digitalsignals (x2) und die Werte der negativen Stützstelle nahe oder gleich dem negativen Fullscalewert des zweiten Digitalsignals (x2) gewählt werden, und dass weiterhin im Falle, dass das erste Digitalsignal (x1) größer Null ist, die Hilfsgröße (p) berechnet wird durch die Gleichung: p:=p+((x1+(xp-x2)*a+b)-p)*d und dass im Falle, dass das erste Digitalsignal (x1) kleiner Null ist, die Hilfsgröße (n) berechnet wird durch die Gleichung: n:=n+((x1+(xn-x2)*a+b)-p)*d wobei d eine sehr kleine Zahl darstellt, beispielsweise 0,001 ist, welche die Rekursionsgeschwindigkeit festlegt, und dass die Berechnung der inversen Verstärkung nach der Berechnungsvorschrift: a=(p-n)/(xp-xn) und die Berechnung des negativen Offsets nach der Berechnungsvorschrift: b=(xp*n-xn*p)/(xp-xn) erfolgt.

Bei einigen Ausführungsformen der zweiten Ausgestaltung ist vorgesehen, dass bei bipolaren Signalen die rekursive Berechnung der inversen Verstärkung und des negativen Offsets auf einer inkrementalen Korrektur beruht, dass eine erste Hilfsgröße (p) und eine zweite Hilfsgröße (n) eingeführt werden, wobei im Falle, dass das erste Digitalsignal (x1) größer Null ist, und falls das erste Digitalsignal (x1) größer als die Multiplikation des zweiten Digitalsignals (x2) mit der angenommenen inversen Verstärkung (a) und der Addition mit dem negativen angenommenen Offset (b) ist (x1>a*x2+b),die erste Hilfsgröße (p) gleich auf den Wert +1 gesetzt wird, und falls das erste Digitalsignal (x1) kleiner als die Multiplikation des zweiten Digitalsignals (x2) mit der angenommenen inversen Verstärkung (a) und der Addition mit dem negativen angenommenen Offset (b) ist (x1 >a*x2+b) die erste Hilfsgröße (p) gleich auf den Wert -1 gesetzt wird, und wobei im Falle, dass das erste Digitalsignal (x1) kleiner Null ist, und falls das erste Digitalsignal (x1) größer als die Multiplikation des zweiten Digitalsignals (x2) mit der angenommenen inversen Verstärkung (a) und der Addition mit dem negativen angenommenen Offset (b) ist (x1>a*x2+b), die zweite Hilfsgröße (n) gleich auf den Wert +1 gesetzt wird, und falls das erste Digitalsignal (x1) kleiner als die Multiplikation des zweiten Digitalsignals (x2) mit der angenommenen inversen Verstärkung (a) und der Addition mit dem negativen angenommenen Offset (b) ist (x1 >a*x2+b), die zweite Hilfsgröße (n) gleich auf den Wert -1 gesetzt wird, und dass weiterhin im Falle, dass falls die erste Hilfsgröße (p) und die zweite Hilfsgröße (n) gleich dem Wert +1 sind, der negative Offset (b) inkrementiert wird, dass falls die erste Hilfsgröße (p) und die zweite Hilfsgröße (n) gleich dem Wert -1 sind der negative Offset (b) dekrementiert wird und die erste und die zweite Hilfsgröße (p)(n) auf den Wert Null gesetzt werden, dass falls die erste Hilfsgröße (p) gleich dem Wert +1 und die zweite Hilfsgröße (n) gleich dem Wert -1 sind, die inversen Verstärkung (a) negative Offset (b) inkrementiert wird und die erste und die zweite Hilfsgröße (p)(n) auf den Wert Null gesetzt werden, dass falls die erste Hilfsgröße (p) gleich dem Wert - 1 und die zweite Hilfsgröße (n) gleich dem Wert +1 sind, die inversen Verstärkung (a) negative Offset (b) dekrementiert wird und die erste und die zweite Hilfsgröße (p)(n) auf den Wert Null gesetzt werden, und dass weiterhin das Dekrementieren und Inkrementieren in hinreichend kleinen Schritten erfolgt.

Bei einigen Ausführungsformen gemäß den beiden Ausgestaltungen wird die erste Schranke (s1) zyklisch berechnet.

Bei einigen Weiterbildungen gemäß den beiden Ausgestaltungen ist vorgesehen, dass bei vernachlässigbar kleinem negativen Offset die erste Schranke (s1) gleich dem Fullscalewert des ersten Digitalsignals (x1) multipliziert mit der angenommenen inversen Verstärkung (a) ist (s1=a*FS).

Bei einigen anderen Weiterbildungen gemäß den beiden Ausgestaltungen ist alternativ vorgesehen, dass die erste Schranke (s1) gleich dem Fullscalewert (FS) des ersten Digitalsignals (x1) multipliziert mit der inversen Verstärkung (a) und der Addition des negativen Offsets (b) ist (s1=a*FS+b).

Bei wieder anderen Weiterbildungen gemäß den beiden Ausgestaltungen ist alternativ vorgesehen, dass bei vernachlässigbar kleinem negativen Offset die erste Schranke (s1) gleich dem Fullscalewert des ersten Digitalsignals (x1) multipliziert mit der angenommenen inversen Verstärkung (a) und multipliziert mit einer Konstanten (c), die typischer Weise etwas kleiner als eins ist, ist (s1=a*c*FS), womit eventuelle interne Übersteuerungen nahe der ersten Schranke (s1) vermieden werden.

Bei noch wieder anderen Weiterbildungen gemäß den beiden Ausgestaltungen ist alternativ vorgesehen, dass die erste Schranke (s1) gleich der Multiplikation einer Konstanten (c), die typischer Weise etwas kleiner als eins ist, mit dem Fullscalewert (FS) des ersten Digitalsignals (x1) multipliziert mit der inversen Verstärkung (a) und der Addition des negativen Offsets (b) ist (s1=c*(a*FS+b)), womit eventuelle interne Übersteuerungen nahe der ersten Schranke (s1) vermieden werden.

Bei einigen Ausführungsformen gemäß der zweiten Ausgestaltung ist vorgesehen, dass die zweite Schranke (s2) zyklisch berechnet wird.

Bei einigen Weiterbildungen gemäß der zweiten Ausgestaltung ist dann vorgesehen, dass die zweite Schranke (s2) gleich der ersten Schranke (s1) multipliziert mit der angenommenen inversen Verstärkung (a) ist (s1=a*s2).

Gemäß den beiden Ausgestaltungen werden ferner Ausführungsformen von Verfahren und Anordnungen zur Analog-Digital-Wandlung von Signalen unter Verwendung mehrerer weniger hochauflösender AD-Wandler vorgeschlagen, wobei das analoge Signal einmal unverstärkt zu einem ersten Digitalsignal (x1) und mehrfach nach einer Signalverarbeitung, im allgemeinen einer fehlerbehafteten Verstärkung größer eins, deren Größen nicht genau bekannt sein müssen, zu mehreren Digitalsignalen (x2....xn) umgewandelt wird, wobei für jeweils zwei Digitalsignale entsprechend wie oben beschrieben verfahren wird, wodurch eine Kaskadierung erfolgt.

Weiterbildungen von allen bisher beschriebenen Ausführungsformen sehen vor, dass auch das analoge Signal zur Gewinnung des ersten Digitalsignal (x1) erst nach einer Signalverarbeitung, im allgemeinen einer fehlerbehafteten Verstärkung, deren Größen nicht genau bekannt sein müssen zu dem Digitalsignal (x1) umgewandelt wird, wodurch insbesondere Laufzeitfehler verkleinert werden.

Ferner wird als Weiterbildung für alle beschriebenen Ausführungsformen der beiden Ausgestaltungen vorgeschlagen nach dem Einschalten, zyklisch oder bei Bedarf ein Kalibriersignal an die Anordnung zur Analog-Digital-Wandlung anzulegen, mit dem die zur Funktion erforderlichen Werte, die oben beschrieben sind, ermittelt werden.

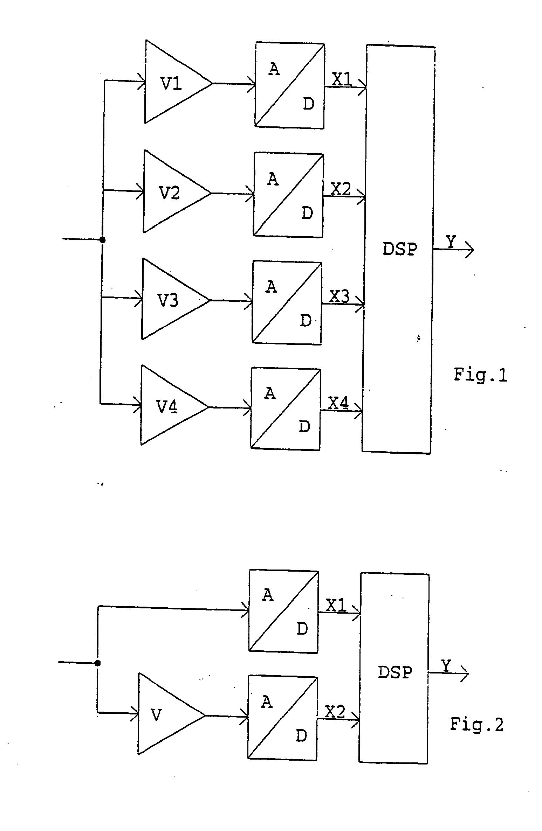

In Fig. 1 und 2 sind schematische Darstellungen von Ausführungsformen von Anordnungen zur Analog-Digital-Wandlung von Signalen gezeigt.

## Patentansprüche

1. Verfahren und Anordnung zur Analog-Digital-Wandlung von Signalen unter Verwendung mindestens zweier weniger hochauflösender AD-Wandler, wobei das analoge Signal einmal unverstärkt zu einem ersten Digitalsignal (x1) und zum anderen nach einer Signalverarbeitung, im allgemeinen einer fehlerbehafteten Verstärkung größer eins, deren Größe nicht genau bekannt sein muss, zu einem zweiten Digitalsignal (x2) umgewandelt wird, wobei in dem Fall, dass
a) der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), sich das digitale Ausgangssignal (y) aus dem ersten Digitalsignal (x1) ergibt (y=x1), und dass im anderen Fall
b) sich das digitale Ausgangssignal (y) aus einer Multiplikation des zweiten Digitalsignals (x2) mit der angenommenen inversen Verstärkung (a) und einer Addition mit einem negativen bekannten Offset (b) ergibt (y=a*x2+b), und weiterhin, dass in diesem Falle die angenommene inverse Verstärkung durch rekursive Berechnung aktualisiert wird.

2. Verfahren zur Analog-Digital-Wandlung nach Anspruch 1, **dadurch gekennzeichnet, dass** die rekursive Berechnung der inversen Verstärkung nach der Formel:
a:=a+(((x1+a*x2-b)/2/x2)-a)*d erfolgt, wobei b den bekannten Offset darstellt und d eine sehr kleine Zahl darstellt, beispielsweise 0,001, welche die Rekursionsgeschwindigkeit festlegt.

3. Verfahren und Anordnung zur Analog-Digital-Wandlung von Signalen unter Verwendung mindestens zweier weniger hochauflösender AD-Wandler, wobei das analoge Signal einmal unverstärkt zu einem ersten Digitalsignal (x1) und zum anderen nach einer Signalverarbeitung, im allgemeinen einer fehlerbehafteten Verstärkung größer eins, deren Größe nicht genau bekannt sein muss, zu einem zweiten Digitalsignal (x2) umgewandelt wird, wobei in dem Fall, dass
a) der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), sich das digitale Ausgangssignal (y) aus dem ersten Digitalsignal (x1) ergibt (y=x1), und dass im anderen Fall
b) sich das digitale Ausgangssignal (y) aus einer Multiplikation des zweiten digitalen Signals (x2) mit der angenommenen inversen Verstärkung (a) und der Addition mit einem negativen angenommenen Offset (b) ergibt (y=a*x2+b), und weiterhin, dass in diesem Falle die angenommene inverse Verstärkung und der angenommene negative Offset durch rekursive Berechnung aktualisiert werden.

4. Verfahren zur Analog-Digital-Wandlung nach Anspruch 3, **dadurch gekennzeichnet, dass** zusätzlich falls der Wert des ersten Digitalsignals (x1) sich in einem Bereich befindet, in dem der Betrag des ersten Signals (s1) eine erste Schranke (s1) unterschreitet jedoch eine zweite, kleinere Schranke (s2) überschreitet (s1>ABS(x1)>s2), die angenommene inverse Verstärkung und der angenommene negative Offset durch rekursive Berechnung aktualisiert werden; denn bei Unterschreitung der zweiten Schwelle (s2) ist die Auflösung des ersten Digitalsignals (x1) derart gering, dass eine rekursive Berechnung nur mit großen Fehlern erfolgen könnte.

5. Verfahren zur Analog-Digital-Wandlung nach Anspruch 3 oder 4, **dadurch gekennzeichnet, dass** in dem Fall,
a) dass der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), sich das digitale Ausgangssignal (y) aus dem ersten Digitalsignal (x1) ergibt (y=x1),
b) dass der Wert des ersten Digitalsignals (x1) sich in einem Bereich befindet, in dem der Betrag des ersten Digitalsignals (x1) die ersten Schranke (s1) unterschreitet und außerdem eine zweite, kleinere Schranke (s2) unterschreitet (ABS(x1)<s2), sich das digitale Ausgangssignal (y) aus einer Multiplikation des zweiten Digitalsignals (x2) mit der angenommenen inversen Verstärkung (a) und der Addition mit dem negativen angenommenen Offset (b) ergibt (y=a*x2+b), und
c) dass, falls keiner der ersten beiden Fälle zutrifft, also der Wert des ersten Digitalsignals (x1) sich in einem Bereich befindet, in dem der Betrag des ersten Signals (s1) eine ersten Schranke (s1) unterschreitet jedoch eine zweite, kleinere Schranke (s2) überschreitet (s1>ABS(x1)>s2), eine Gewichtsfunktion gebildet wird, die ein Überblenden zwischen beiden in den ersten Fällen beschriebenen Berechnungsvorschriften gestattet, in der Weise, dass das digitale Ausgangssignal (y) gebildet wird aus der Summe des mit dem Gewicht (g) multiplizierten ersten Digitalsignals(x1) und der mit dem inversen Gewicht (1-g) multiplizierten Summe aus dem negativen angenommenen Offset (b) und der Multiplikation des zweiten Digitalsignals (x2) mit der angenommenen inversen Verstärkung (a),(y=g*x1+(1-g)*(a*x2+b)) und außerdem die angenommene inverse Verstärkung und der angenommene negative Offset durch rekursive Berechnung aktualisiert werden.

6. Verfahren zur Analog-Digital-Wandlung nach Anspruch 5, **dadurch gekennzeichnet, dass** das Gewicht (g) eine lineare Funktion ist und gleich dem Quotienten aus der Differenz zwischen dem Betrag des ersten Digitalsignals (x1) und der zweiten Schwelle (s2) geteilt durch die Differenz zwischen der ersten Schwelle (s1) und der zweiten Schwelle (s2) ist (g=(ABS(x1)-S2)/(s1-s2)).

7. Verfahren zur Analog-Digital-Wandlung nach Anspruch 1 bis 6, **dadurch gekennzeichnet, dass** in dem Fall, dass der Wert des zweiten Digitalsignals (x2) sich mit großer Wahrscheinlichkeit in einem Bereich befindet, in dem er durch Übersteuerung hervorgerufen wurde, zweckmäßiger Weise durch Überschreitung einer ersten Schranke (s1) des Betrages des ersten Digitalsignals (x1) ermittelt (ABS(x1)>s1), und auch in dem Fall, dass die Zeit seit der letzten Überschreitung des Betrages des ersten Digitalsignals (x1) über die erste Schranke (s1) (ABS(x1)>s1) kleiner als eine vorgegebene Zeit (t) ist, sich das digitale Ausgangssignal (y) aus dem ersten Digitalsignal (x1) ergibt, wobei in den anderen Fällen wie zuvor beschrieben verfahren wird.

8. Verfahren zur Analog-Digital-Wandlung nach Anspruch 7, **dadurch gekennzeichnet, dass** bei periodischen Abtastungen des Signals die Anzahl der Perioden nach Überschreitung des Betrages des ersten Digitalsignals (x1) über die erste Schranke (s1) gezählt werden, um ein Maß für die Zeit (t) zu erhalten.

9. Verfahren zur Analog-Digital-Wandlung nach Anspruch 3 bis 8, **dadurch gekennzeichnet, dass** die rekursive Berechnung der inversen Verstärkung und des negativen Offsets nur bei langsamen Signaländerungen erfolgt, ermittelt aus der Unterschreitung der Differenz aus dem letzten und dem aktuellen Wert des ersten Digitalsignals (x1) oder des zweiten Digitalsignals (x2) unter den Wert einer differenziellen Schranke (s3), wodurch ein Fehler, hervorgerufen durch eine Signallaufzeitdifferenz des zweiten Digitalsignals (x2) in der Signalverarbeitungsstufe gegenüber dem ersten digitalen Digitalsignal (x1), minimiert werden kann.

10. Verfahren zur Analog-Digital-Wandlung nach Anspruch 9, **dadurch gekennzeichnet, dass** bei Überschreitung der differenziellen Schranke (s3) eine rekursive Berechnung der Laufzeitdifferenz erfolgt, dass ein drittes Digitalsignal (x3) berechnet wird, welches dem zweiten Digitalsignal (x2) verzögert um die berechnete Laufzeit entspricht, und dass das dritte Digitalsignal (x3) an Stelle des zweiten Digitalsignals (x2) in den Gleichungen zur Berechnung des digitalen Ausgangssignals (y) verwendet wird.

11. Verfahren zur Analog-Digital-Wandlung nach Anspruch 10, **dadurch gekennzeichnet, dass** bei Überschreitung der differenziellen Schranke (s3) eine rekursive Berechnung der Laufzeitdifferenz basierend auf einer Tiefpasslaufzeit erfolgt, dass ein drittes Digitalsignal (x3) berechnet wird, welches dem zweiten Digitalsignal (x2) gefiltert mit dem berechneten Tiefpass entspricht, und dass das dritte Digitalsignal (x3) an Stelle des zweiten Digitalsignals (x2) in den Gleichungen zur Berechnung des digitalen Ausgangssignals (y) verwendet wird.

12. Verfahren zur Analog-Digital-Wandlung nach Anspruch 1 bis 11, **dadurch gekennzeichnet, dass** im Falle unipolarer analoger Signale die Betragsbildung des ersten Digitalsignals (x1) beim Vergleich mit der ersten Schranke (s1) entfallen kann.

13. Verfahren zur Analog-Digital-Wandlung nach Anspruch 3 bis 12, **dadurch gekennzeichnet, dass** die rekursive Berechnung der inversen Verstärkung nach der Berechnungsvorschrift: a:=a+(((x1+a*x2-b)/2/x2)-a)*d erfolgt, wobei d eine sehr kleine Zahl darstellt, beispielsweise 0,001, welche die Rekursionsgeschwindigkeit festlegt, und dass der angenommene negative Offset durch rekursive Berechnung aktualisiert wird nach der Berechnungsvorschrift: b:=b+(((x1-a*x2+b)/2)-b)*d, wobei d, ohne Beschränkung der Allgemeinheit, gleich dem oben aufgeführten Wert d ist.

14. Verfahren zur Analog-Digital-Wandlung nach Anspruch 3 bis 12, **dadurch gekennzeichnet, dass** bei bipolaren Signalen die rekursive Berechnung der inversen Verstärkung und des negativen Offsets auf einer positiven Hilfsgröße (p) und einer negativen Hilfsgröße (n) beruhen, wobei die positive Hilfsgröße (p) an der positiven Stützstelle (xp) berechnet wird und die negative Hilfsgröße (n) an der negativen Stützstelle (xn) berechnet wird, und wobei die Werte der positiven Stützstelle nahe oder gleich dem positiven Fullscalewert des zweiten Digitalsignals (x2) und die Werte der negativen Stützstelle nahe oder gleich dem negativen Fullscalewert des zweiten Digitalsignals (x2) gewählt werden, und dass weiterhin im Falle, dass das erste Digitalsignal (x1) größer Null ist, die Hilfsgröße (p) berechnet wird durch die Gleichung: p:=p+((x1+(xp-x2)*a+b)-p)*d und dass im Falle, dass das erste Digitalsignal (x1) kleiner Null ist, die Hilfsgröße (n) berechnet wird durch die Gleichung: n:=n+((x1+(xn-x2)*a+b)-p)*d wobei d eine sehr kleine Zahl darstellt, beispielsweise 0,001 ist, welche die Rekursionsgeschwindigkeit festlegt, und dass die Berechnung der inversen Verstärkung nach der Berechnungsvorschrift: a=(p-n)/(xp-xn) und die Berechnung des negativen Offsets nach der Berechnungsvorschrift: b=(xp*n-xn*p)/(xp-xn) erfolgt.

15. Verfahren zur Analog-Digital-Wandlung nach Anspruch 3 bis 12, **dadurch gekennzeichnet, dass** bei bipolaren Signalen die rekursive Berechnung der inversen Verstärkung und des negativen Offsets auf einer inkrementalen Korrektur beruht, dass eine erste Hilfsgröße (p) und eine zweite Hilfsgröße (n) eingeführt werden, wobei im Falle, dass das erste Digitalsignal (x1) größer Null ist, und falls das erste Digitalsignal (x1) größer als die Multiplikation des zweiten Digitalsignals (x2) mit der angenommenen inversen Verstärkung (a) und der Addition mit dem negativen angenommenen Offset (b) ist (x1>a*x2+b),die erste Hilfsgröße (p) gleich auf den Wert +1 gesetzt wird, und falls das erste Digitalsignal (x1) kleiner als die Multiplikation des zweiten Digitalsignals (x2) mit der angenommenen inversen Verstärkung (a) und der Addition mit dem negativen angenommenen Offset (b) ist (x1>a*x2+b) die erste Hilfsgröße (p) gleich auf den Wert -1 gesetzt wird, und wobei im Falle, dass das erste Digitalsignal (k1) kleiner Null ist, und falls das erste Digitalsignal (x1) größer als die Multiplikation des zweiten Digitalsignals (x2) mit der angenommenen inversen Verstärkung (a) und der Addition mit dem negativen angenommenen Offset (b) ist (x1>a*x2+b), die zweite Hilfsgröße (n) gleich auf den Wert +1 gesetzt wird, und falls das erste Digitalsignal (x1) kleiner als die Multiplikation des zweiten Digitalsignals (x2) mit der angenommenen inversen Verstärkung (a) und der Addition mit dem negativen angenommenen Offset (b) ist (x1>a*x2+b), die zweite Hilfsgröße (n) gleich auf den Wert -1 gesetzt wird, und dass weiterhin im Falle, dass falls die erste Hilfsgröße (p) und die zweite Hilfsgrößse (n) gleich dem Wert +1 sind, der negative Offset (b) inkrementiert wird, dass falls die erste Hilfsgröße (p) und die zweite Hilfsgröße (n) gleich dem Wert -1 sind der negative Offset (b) dekrementiert wird und die erste und die zweite Hilfsgröße (p)(n) auf den Wert Null gesetzt werden, dass falls die erste Hilfsgröße (p) gleich dem Wert +1 und die zweite Hilfsgröße (n) gleich dem Wert -1 sind, die inversen Verstärkung (a) negative Offset (b) inkrementiert wird und die erste und die zweite Hilfsgröße (p)(n) auf den Wert Null gesetzt werden, dass falls die erste Hilfsgröße (p) gleich dem Wert -1 und die zweite Hilfsgröße (n) gleich dem Wert +1 sind, die inversen Verstärkung (a) negative Offset (b) dekrementiert wird und die erste und die zweite Hilfsgröße (p)(n) auf den Wert Null gesetzt werden, und dass weiterhin das Dekrementieren und Inkrementieren in hinreichend kleinen Schritten erfolgt.

16. Verfahren zur Analog-Digital-Wandlung nach Anspruch 1 bis 15, **dadurch gekennzeichnet, dass** die erste Schranke (s1) zyklisch berechnet wird.

17. Verfahren zur Analog-Digital-Wandlung nach Anspruch 16, **dadurch gekennzeichnet, dass** bei vernachlässigbar kleinem negativen Offset die erste Schranke (s1) gleich dem Fullscalewert des ersten Digitalsignals (x1) multipliziert mit der angenommenen inversen Verstärkung (a) ist (s1=a*FS).

18. Verfahren zur Analog-Digital-Wandlung nach Anspruch 16, **dadurch gekennzeichnet, dass** die erste Schranke (s1) gleich dem Fullscalewert (FS) des ersten Digitalsignals (x1) multipliziert mit der inversen Verstärkung (a) und der Addition des negativen Offsets (b) ist (s1=a*FS+b).

19. Verfahren zur Analog-Digital-Wandlung nach Anspruch 16, **dadurch gekennzeichnet, dass** bei vernachlässigbar kleinem negativen Offset die erste Schranke (s1) gleich dem Fullscalewert des ersten Digitalsignals (x1) multipliziert mit der angenommenen inversen Verstärkung (a) und multipliziert mit einer Konstanten (c), die typischer Weise etwas kleiner als eins ist, ist (s1=a*c*FS), womit eventuelle interne Übersteuerungen nahe der ersten Schranke (s1) vermieden werden.

20. Verfahren zur Analog-Digital-Wandlung nach Anspruch 16, **dadurch gekennzeichnet, dass** die erste Schranke (s1) gleich der Multiplikation einer Konstanten (c), die typischer Weise etwas kleiner als eins ist, mit dem Fullscalewert (FS) des ersten Digitalsignals (x1) multipliziert mit der inversen Verstärkung (a) und der Addition des negativen Offsets (b) ist (s1=c*(a*FS+b)), womit eventuelle interne Übersteuerungen nahe der ersten Schranke (s1) vermieden werden.

21. Verfahren zur Analog-Digital-Wandlung nach Anspruch 4 bis 20, **dadurch gekennzeichnet, dass** die zweite Schranke (s2) zyklisch berechnet wird.

22. Verfahren zur Analog-Digital-Wandlung nach Anspruch 21, **dadurch gekennzeichnet, dass** die zweite Schranke (s2) gleich der ersten Schranke (s1) multipliziert mit der angenommenen inversen Verstärkung (a) ist (s1=a*s2).

23. Verfahren und Anordnung zur Analog-Digital-Wandlung von Signalen unter Verwendung mehrerer weniger hochauflösender AD-Wandler, **dadurch gekennzeichnet, dass** das analoge Signal einmal unverstärkt zu einem ersten Digitalsignal (x1) und mehrfach nach einer Signalverarbeitung, im allgemeinen einer fehlerbehafteten Verstärkung größer eins, deren Größen nicht genau bekannt sein müssen, zu mehreren Digitalsignalen (x2....xn) umgewandelt wird, wobei für jeweils zwei Digitalsignale entsprechend den Ansprüchen 1 bis 22 verfahren wird, wodurch eine Kaskadierung erfolgt.

24. Verfahren und Anordnung zur Analog-Digital-Wandlung von Signalen nach Anspruch 1 bis 23, **dadurch gekennzeichnet, dass** auch das analoge Signal zur Gewinnung des ersten Digitalsignal (x1) erst nach einer Signalverarbeitung, im allgemeinen einer fehlerbehafteten Verstärkung, deren Größen nicht genau bekannt sein müssen zu dem Digitalsignal (x1) umgewandelt wird, wodurch insbesondere Laufzeitfehler verkleinert werden.

25. Verfahren zur Analog-Digital-Wandlung nach Anspruch 1 bis 24, **dadurch gekennzeichnet, dass** nach dem Einschalten, zyklisch oder bei Bedarf ein Kalibriersignal an die Anordnung zur Analog-Digital-Wandlung gelegt wird, mit dem die zur Funktion erforderlichen Werte, die in Ansprüchen 1 bis 24 beschrieben sind, ermittelt werden.

## Claims

1. Method and circuit for analogue-to-digital conversion of signals using at least two lower-resolution AD converters, wherein the analogue signal, on the one hand, is converted unamplified to a first digital signal (x1) and, on the other hand, after signal processing, generally an error-prone amplification greater than one the value of which need not be accurately known, to a second digital signal (x2), wherein, in case that
a) the value of the second digital signal (x2), most likely, is in a range in which it was caused by overloading, expediently determined by exceeding a first bound (s1) of the amount of the first digital signal (x1) (ABS(x1)>s1), the digital output signal (y) results from the first digital signal (x1) (y=x1), and that in the other case
b) the digital output signal (y) results from a multiplication of the second digital signal (x2) with the assumed inverse amplification (a) and an addition with a negative known offset (b) (y=a*x2+b), and furthermore that, in this case, the assumed inverse amplification is updated by recursive calculation.

2. Method for analogue-to-digital conversion according to claim 1, **characterised in that** the recursive calculation of the inverse amplification is performed according to the formula a:=a+(((x1+a*x2-b)/2/x2)-a)*d, wherein b represents the known offset and d represents a very small number, for example 0.001, which defines the recursion speed.

3. Method and circuit for analogue-to-digital conversion of signals using at least two lower-resolution AD converters, wherein the analogue signal, on the one hand, is converted unamplified to a first digital signal (x1) and, on the other hand, after signal processing, generally an error-prone amplification greater than one the value of which need not be accurately known, to a second digital signal (x2), wherein, in the case that
a) the value of the second digital signal (x2), most likely, is in a range in which it was caused by overloading, expediently determined by exceeding a first bound (s1) of the amount of the first digital signal (x1) (ABS(x1)>s1), the digital output signal (y) results from the first digital signal (x1) (y=x1), and that in the other case
b) the digital output signal (y) results from a multiplication of the second digital signal (x2) with the assumed inverse amplification (a) and the addition with a negative assumed offset (b) (y=a*x2+b), and furthermore that, in this case, the assumed inverse amplification and the assumed negative offset are updated by recursive calculation.

4. Method for analogue-to-digital conversion according to claim 3, **characterised in that**, additionally, if the value of the first digital signal (x1) is in a range in which the amount of the first signal (s1) is below a first bound (s1) but exceeds a second, smaller bound (s2) (s1>ABS(x1)>s2), the assumed inverse amplification and the assumed negative offset are updated by recursive calculation; for, when going below the second threshold (s2), the resolution of the first digital signal (x1) is so low that a recursive calculation could only be performed with large errors.

5. Method for analogue-to-digital conversion according to claim 3 or 4, **characterised in that** in case
a) that the value of the second digital signal (x2), most likely, is in a range in which it was caused by overloading, expediently determined by exceeding a first bound (s1) of the amount of the first digital signal (x1) (ABS(x1)>s1), the digital output signal (y) results from the first digital signal (x1) (y=x1),
b) that the value of the first digital signal (x1) is in a range in which the amount of the first digital signal (x1) is below the first bound (s1) and also is below a second, smaller bound (s2) (ABS(x1)<s2), the digital output signal (y) results from a multiplication of the second digital signal (x2) with the assumed inverse amplification (a) and the addition with the negative assumed offset (b) (y=a*x2+b), and
c) that, if none of the first two cases applies, hence the value of the first digital signal (x1) is in a range in which the amount of the first signal (s1) is below a first bound (s1) but exceeds a second, smaller bound (s2) (s1>ABS(x1)>s2), a weight function is generated which allows fade-over between both calculation rules described in the first cases, in the manner that the digital output signal (y) is formed from the sum of the first digital signal (x1) multiplied with the weight (g) and the sum, multiplied with the inverse weight (1-g), from the negative assumed offset (b) and the multiplication of the second digital signal (x2) with the assumed inverse amplification (a),(y=g*x1+(1-g)*(a*x2+b)) and also the assumed inverse amplification and the assumed negative offset are updated by recursive calculation.

6. Method for analogue-to-digital conversion according to claim 5, **characterised in that** the weight (g) is a linear function and is equal to the quotient of the difference between the amount of the first digital signal (x1) and the second threshold (s2) divided by the difference between the first threshold (s1) and the second threshold (s2) (g=(ABS(x1)-S2)/(s1-s2)).

7. Method for analogue-to-digital conversion according to any one of claims 1 to 6, **characterised in that** in case the value of the second digital signal (x2), most likely, is in a range in which it was caused by overloading, expediently determined by exceeding a first bound (s1) of the amount of the first digital signal (x1) (ABS(x1)>s1), and also in case that the time since the last exceeding of the amount of the first digital signal (x1) over the first bound (s1) (ABS(x1)>s1) is smaller than a specified time (t), the digital output signal (y) results from the first digital signal (x1), wherein the previously described method is adopted in the other cases.

8. Method for analogue-to-digital conversion according to claim 7, **characterised in that**, during periodic scans of the signal, the number of periods after exceeding the amount of the first digital signal (x1) over the first bound (s1) is counted in order to obtain a measure for the time (t).

9. Method for analogue-to-digital conversion according to any one of claims 3 to 8, **characterised in that** the recursive calculation of the inverse amplification and of the negative offset is only performed for slow signal changes, determined from going below the difference of the last and the current value of the first digital signal (x1) or of the second digital signal (x2) under the value of a differential bound (s3), whereby an error caused by a signal runtime difference of the second digital signal (x2) at the signal processing stage can be minimised compared to the first digital digital signal (x1).

10. Method for analogue-to-digital conversion according to claim 9, **characterised in that**, when exceeding the differential bound (s3), the recursive calculation of the runtime difference is performed, that a third digital signal (x3) is calculated, which corresponds to the second digital signal (x2) delayed by the calculated runtime, and that the third digital signal (x3) is used instead of the second digital signal (x2) in the equations for calculating the digital output signal (y).

11. Method for analogue-to-digital conversion according to claim 10, **characterised in that**, when exceeding the differential bound (s3), a recursive calculation of the runtime difference is performed based on a low-pass runtime, that a third digital signal (x3) is calculated, which corresponds to the second digital signal (x2) filtered with the calculated low-pass, and that the third digital signal (x3) is used instead of the second digital signal (x2) in the equations for calculating the digital output signal (y).

12. Method for analogue-to-digital conversion according to any one of claims 1 to 11, **characterised in that**, in case of unipolar analogue signals, the amount of the first digital signal (x1) need not be computed during comparison with the first bound (s1).

13. Method for analogue-to-digital conversion according to any one of claims 3 to 12, **characterised in that** the recursive calculation of the inverse amplification is performed according to the calculation rule a:=a+(((x1+a*x2-b)/2/x2)-a)*d, wherein d represents a very small number, for example 0.001, which defines the recursion speed, and that the assumed negative offset is updated by recursive calculation according to the calculation rule b:=b+(((x1-a*x2+b)/2)-b)*d, wherein d, without limiting the generality, is equal to the above-mentioned value d.

14. Method for analogue-to-digital conversion according to any one of claims 3 to 12, **characterised in that**, for bipolar signals, the recursive calculation of the inverse amplification and of the negative offset is based on a positive auxiliary quantity (p) and a negative auxiliary quantity (n), wherein the positive auxiliary quantity (p) is calculated at the positive node (xp) and the negative auxiliary quantity (n) is calculated at the negative node (xn), and wherein the values of the positive node are selected near or equal to the positive full-scale value of the second digital signal (x2) and the values of the negative node are selected near or equal to the negative full-scale value of the second digital signal (x2), and that, furthermore, in case the first digital signal (x1) is greater than zero, the auxiliary quantity (p) is calculated by the equation p:=p+((x1+(xp-x2)*a+b)-p)*d and that, in case the first digital signal (x1) is smaller than zero, the auxiliary quantity (n) is calculated by the equation n:=n+((x1+(xn-x2)*a+b)-p)*d, wherein d represents a very small number, for example 0.001, which defines the recursion speed, and that the calculation of the inverse amplification is performed according to the calculation rule: a=(p-n)/(xp-xn) and the calculation of the negative offset according to the calculation rule b=(xp*n-xn*p)/(xp-xn).

15. Method for analogue-to-digital conversion according to any one of claims 3 to 12, **characterised in that**, for bipolar signals, the recursive calculation of the inverse amplification and of the negative offset is based on an incremental correction, that a first auxiliary quantity (p) and a second auxiliary quantity (n) are introduced, wherein, in case the first digital signal (x1) is greater than zero, and if the first digital signal (x1) is greater than the multiplication of the second digital signal (x2) with the assumed inverse amplification (a) and the addition with the negative assumed offset (b) (x1>a*x2+b), the first auxiliary quantity (p) is immediately set to the value +1, and if the first digital signal (x1) is smaller than the multiplication of the second digital signal (x2) with the assumed inverse amplification (a) and the addition with the negative assumed offset (b) (x1>a*x2+b), the first auxiliary quantity (p) is immediately set to the value -1, and wherein, in case the first digital signal (x1) is smaller than zero, and if the first digital signal (x1) is greater than the multiplication of the second digital signal (x2) with the assumed inverse amplification (a) and the addition with the negative assumed offset (b) (x1>a*x2+b), the second auxiliary quantity (n) is immediately set to the value +1, and if the first digital signal (x1) is smaller than the multiplication of the second digital signal (x2) with the assumed inverse amplification (a) and the addition with the negative assumed offset (b) (x1>a*x2+b), the second auxiliary quantity (n) is immediately set to the value -1, and that, furthermore, in case the first auxiliary quantity (p) and the second auxiliary quantity (n) are equal to the value +1, the negative offset (b) is incremented, that, if the first auxiliary quantity (p) and the second auxiliary quantity (n) are equal to the value -1, the negative offset (b) is decremented and the first and the second auxiliary quantities (p)(n) are set to the value zero, that, if the first auxiliary quantity (p) is equal to the value +1 and the second auxiliary quantity (n) is equal to the value -1, the inverse amplification (a) negative offset (b) is incremented and the first and the second auxiliary quantities (p)(n) are set to the value zero, that, if the first auxiliary quantity (p) is equal to the value -1 and the second auxiliary quantity (n) is equal to the value +1, the inverse amplification (a) negative offset (b) is decremented and the first and the second auxiliary quantities (p)(n) are set to the value zero and that, furthermore, the decrementing and incrementing are performed in sufficiently small steps.

16. Method for analogue-to-digital conversion according to any one of claims 1 to 15, **characterised in that** the first bound (s1) is calculated cyclically.

17. Method for analogue-to-digital conversion according to claim 16, **characterised in that**, for a negligibly small negative offset, the first bound (s1) is equal to the full-scale value of the first digital signal (x1) multiplied with the assumed inverse amplification (a) (s1=a*FS).

18. Method for analogue-to-digital conversion according to claim 16, **characterised in that** the first bound (s1) is equal to the full-scale value (FS) of the first digital signal (x1) multiplied with the inverse amplification (a) and the addition of the negative offset (b) (s1=a*FS+b).

19. Method for analogue-to-digital conversion according to claim 16, **characterised in that**, for a negligibly small negative offset, the first bound (s1) is equal to the full-scale value of the first digital signal (x1) multiplied with the assumed inverse amplification (a) and multiplied with a constant (c) which, typically, is slightly smaller than one (s1=a*c*FS), whereby any internal overloads near the first bound (s1) are avoided.

20. Method for analogue-to-digital conversion according to claim 16, **characterised in that** the first bound (s1) is equal to the multiplication of a constant (c) which, typically, is slightly smaller than one, with the full-scale value (FS) of the first digital signal (x1) multiplied with the inverse amplification (a) and the addition of the negative offset (b) (s1=c*(a*FS+b)), whereby any internal overloads near the first bound (s1) are avoided.

21. Method for analogue-to-digital conversion according to any one of claims 4 to 20, **characterised in that** the second bound (s2) is calculated cyclically.

22. Method for analogue-to-digital conversion according to claim 21, **characterised in that** the second bound (s2) is equal to the first bound (s1) multiplied with the assumed inverse amplification (a) (s1=a*s2).

23. Method and circuit for the analogue-to-digital conversion of signals using several lower-resolution AD converters, **characterised in that** the analogue signal is converted, on the one hand, unamplified to a first digital signal (x1) and repeatedly after signal processing, generally an error-prone amplification greater than one the values of which need not be accurately known, to several digital signals (x2....xn), wherein, for two digital signals each, a method is adopted according to the claims 1 to 22, whereby cascading takes place.

24. Method and circuit for the analogue-to-digital conversion of signals according to any one of claims 1 to 23, **characterised in that** also the analogue signal for gaining the first digital signal (x1) is converted only after signal processing, generally an error-prone amplification the values of which need not be accurately known, to the digital signal (x1), whereby, in particular, runtime errors are minimised.

25. Method for analogue-to-digital conversion according to any one of claims 1 to 24, **characterised in that**, after switching-on, cyclically or as required, a calibration signal is applied to the arrangement for analogue-to-digital conversion with which the values required for functioning, said values being described in claims 1 to 24, are determined.

## Revendications

1. Procédé et dispositif de conversion analogique-numérique de signaux au moyen d'au moins deux convertisseurs AN (convertisseurs analogiques-numériques) pas à haute résolution, dans lesquels le signal analogique, est converti une fois non amplifié en un premier signal numérique (x1) et d'autre part, après un traitement de signal, en général une amplification entachée d'erreurs, supérieure à 1 dont la grandeur ne doit pas être connue avec précision, est converti en un deuxième signal numérique (x2), dans lesquels dans le cas où
a) la valeur du deuxième signal numérique (x2) se trouve avec une grande vraisemblance dans une plage dans laquelle elle a été amenée par saturation, déterminée de manière appropriée par un dépassement par le haut d'une première limite (s1) du module du premier signal numérique (x1), (ABS(x1)>s1), le signal de sortie numérique (y) résulte du premier signal numérique (x1) (y=x1), et, dans l'autre cas,
b) le signal de sortie numérique (y) résulte d'une multiplication du deuxième signal numérique (x2) par l'amplification inverse supposée (a) et d'une addition avec un décalage négatif connu (b), (y=a*x2+b), et par ailleurs que, dans ce cas, l'amplification inverse supposée est actualisée par un calcul récursif.

2. Procédé de conversion analogique-numérique selon la revendication 1, **caractérisé en ce que** le calcul récursif de l'amplification inverse est effectué selon la formule :
a:=a+(((x1+a*x2-b)/2/x2)-a)*d, où b représente le décalage connu et d représente un nombre très petit, par exemple égal à 0,001, qui détermine la vitesse de récurrence.

3. Procédé et dispositif de conversion analogique-numérique de signaux au moyen d'au moins deux convertisseurs AN pas à haute résolution, selon lesquels le signal analogique est converti une fois non amplifié en un premier signal numérique (x1) et, d'autre part après un traitement de signal, en général une amplification entachée d'erreur, supérieure à 1, dont la grandeur ne doit pas être connue avec précision, est converti en un deuxième signal numérique (x2), selon lesquels dans le cas où
a) la valeur du deuxième signal numérique (x2) se trouve avec une grande vraisemblance dans une plage dans laquelle elle a été amenée par saturation, déterminée de manière appropriée par dépassement par le haut d'une première limite (s1) du module du premier signal numérique (x1), (ABS(x1)>s1), le signal de sortie numérique (y) résulte du premier signal numérique (x1) (y=x1), et, dans l'autre cas,
b) le signal de sortie numérique (y) résulte d'une multiplication du deuxième signal numérique (x2) par l'amplification inverse supposée (a) et d'une addition avec un décalage négatif supposé (b), (y=a*x2+b), et par ailleurs que, dans ce cas, l'amplification inverse supposée et le décalage négatif supposé sont actualisés par un calcul récursif.

4. Procédé de conversion analogique-numérique selon la revendication 3, **caractérisé en ce que**, en plus du cas où la valeur du premier signal numérique (x1) se trouve dans une plage dans laquelle le module du premier signal (s1) dépasse par le bas une première limite (s1), mais dépasse par le haut une deuxième limite plus petite (s2) (s1>ABS(x1)>s2), l'amplification inverse supposée et le décalage supposé sont actualisés par un calcul récursif ; ensuite en cas de dépassement par le bas du deuxième seuil (s2), la résolution du premier signal numérique (x1) est si faible qu'un calcul récursif pourrait avoir lieu uniquement avec de grandes erreurs.

5. Procédé de conversion analogique-numérique selon la revendication 3 ou 4, **caractérisé en ce que**, dans le cas
a) où la valeur du deuxième signal numérique (x2) se trouve avec une grande vraisemblance dans une plage dans laquelle elle a été amenée par saturation, déterminée de manière appropriée par dépassement par le haut d'une première limite (s1) du module du premier signal numérique (x1), (ABS(x1)>s1), le signal de sortie numérique (y) résulte du premier signal numérique (x1) (y=x1),
b) où la valeur du premier signal numérique (x1) se trouve dans une plage dans laquelle le module du premier signal numérique (x1) dépasse par le bas la première limite (s1) et que, en outre, il dépasse par le haut une deuxième limite plus petite (s2) (ABS(x1)<s2), le signal de sortie numérique (y) résulte d'une multiplication du deuxième signal numérique (x2) par l'amplification inverse supposée (a) et de l'addition avec le décalage négatif supposé (b) (y=a*x2+b), et
c) où, si aucun des deux premiers cas ne se produit, la valeur du premier signal numérique (x1) se trouve donc dans une plage dans laquelle le module du premier signal (s1) dépasse par le bas une première limite (s1), mais dépasse par le haut une deuxième limite plus petite (s2) (s1>ABS(x1)>s2), il est formé une fonction de pondération qui autorise une combinaison entre les deux directives de calcul décrites dans les premiers cas d'une manière telle que le signal de sortie numérique (y) soit formé par la somme du premier signal numérique (x1) multiplié par la première pondération (g) et par la somme, multipliée par la pondération inverse (1-g), du décalage négatif supposé (b) et de la multiplication du deuxième signal numérique (x2) par l'amplification inverse supposée (a), (y=g*x1+(1-g)*(a*x2+b)) et, en outre, l'amplification inverse supposée et le décalage négatif supposé sont actualisés par un calcul récursif.

6. Procédé de conversion analogique-numérique selon la revendication 5, **caractérisé en ce que**, la pondération (g) est une fonction linéaire et est égale au quotient de la différence entre le module du premier signal numérique (x1) et le deuxième seuil (s2) divisée par la différence entre le premier seuil (s1) et le deuxième seuil (s2) (g=(ABS(x1)-S2)/ (s1-s2)).

7. Procédé de conversion analogique-numérique selon la revendication 1 à 6, **caractérisé en ce que**, dans le cas où la valeur du deuxième signal numérique (x2) se trouve avec grande vraisemblance dans une plage dans laquelle elle a été amenée par saturation, déterminée de manière appropriée par dépassement par le haut d'une première limite (s1) du module du premier signal numérique (x1) (ABS(x1)>s1), et également dans le cas où le temps depuis le dernier dépassement par le haut du montant du premier signal numérique (x1) au-delà de la première limite (s1) (ABS(x1)>s1) est inférieur à un temps prédéfini (t), le signal de sortie numérique résulte (y) du premier signal numérique (x1), dans les autres cas, les procédés décrits précédemment s'appliquent.

8. Procédé de conversion analogique-numérique selon la revendication 7, **caractérisé en ce que**, lors de balayages périodiques du signal, on compte le nombre de périodes après le dépassement par le haut du module du premier signal numérique (x1) au-delà de la première limite (s1) afin d'obtenir une grandeur pour le temps (t).

9. Procédé de conversion analogique-numérique selon la revendication 3 à 8, **caractérisé en ce que** le calcul récursif de l'amplification inverse et du décalage négatif sont effectués uniquement en cas de variations lentes du signal, déterminées d'après le dépassement par le bas de la différence entre la dernière valeur et la valeur actuelle du premier signal numérique (x1) ou du deuxième signal numérique (x2) en dessous de la valeur d'une limite différentielle (s3), ce qui permet de minimiser une erreur, provoquée par une différence temporelle du deuxième signal numérique (x2), survenant au cours de l'étape de traitement de signal, par rapport au premier signal numérique (x1).

10. Procédé de conversion analogique-numérique selon la revendication 9, **caractérisé en ce que**, en cas de dépassement par le haut de la limite différentielle (s3), on effectue un calcul récursif de différence de temps de propagation, que l'on calcule un troisième signal numérique (x3) qui correspond au deuxième signal numérique (x2) retardé du temps de propagation calculé, et que l'on emploie le troisième signal numérique (x3) à la place du deuxième signal numérique (x2) dans les équations servant à calculer le signal de sortie numérique (y).

11. Procédé de conversion analogique-numérique selon la revendication 10, **caractérisé en ce que**, en cas de dépassement par le haut de la limite différentielle (s3), on effectue un calcul récursif de la différence de temps de propagation sur la base d'un temps de propagation d'un filtre passe-bas, que l'on calcule un troisième signal numérique (x3) qui correspond au deuxième signal numérique (x2) filtré avec le filtre passe-bas calculé, et que l'on emploie le troisième signal numérique (x3) à la place du deuxième signal numérique (x2) dans les équations servant à calculer le signal de sortie numérique (y).

12. Procédé de conversion analogique-numérique selon la revendication 1 à 11, **caractérisé en ce que**, dans le cas de signaux analogiques unipolaires, on peut se passer de la formation du module du premier signal numérique (x1) en cas de comparaison avec la première limite (s1).

13. Procédé de conversion analogique-numérique selon la revendication 3 à 12, **caractérisé en ce que**, le calcul récursif de l'amplification inverse est effectué d'après la directive de calcul : a:=a+(((x1+a*x2-b)/2/x2)-a)*d, où d représente un nombre très petit, par exemple égal à 0,001, qui détermine la vitesse de récurrence, et **en ce que** le décalage négatif supposé est actualisé par un calcul récursif d'après la directive de calcul : b:=b+(((x1-a*x2+b)/2)-b)*d, où d, sans limitation du caractère général, est égal à la valeur d susmentionnée.

14. Procédé de conversion analogique-numérique selon la revendication 3 à 12, **caractérisé en ce que**, en cas de signaux bipolaires, le calcul récursif de l'amplification inverse et du décalage négatif reposent sur une grandeur auxiliaire positive (p) et une grandeur auxiliaire négative (n), la grandeur auxiliaire positive (p) étant calculée au point d'appui positif (xp) et la grandeur auxiliaire négative (n) est calculée au point d'appui négatif (xn), et les valeurs du point d'appui positif étant choisies proches de la valeur finale positive de l'échelle du deuxième signal numérique (x2) ou égales à ces dernières et les valeurs du point d'appui négatif étant choisies proches de la valeur finale négative de l'échelle du deuxième signal numérique (x2) ou égales à ces dernières, et **en ce que**, en outre dans le cas où le premier signal numérique (x1) est supérieur à zéro, la grandeur auxiliaire (p) est calculée par l'équation : p:=p+((x1+(xp-x2)*a+b)-p)*d et **en ce que**, dans le cas où le premier signal numérique (x1) est inférieur à zéro, la grandeur auxiliaire (n) est calculée par l'équation : n:=n+((x1+(xn-x2)*a+b)-p)*d, où d représente un très petit nombre, par exemple égal à 0,001, qui détermine la vitesse de récurrence, et **en ce que** le calcul de l'amplification inverse est effectué d'après la directive de calcul :
a=(p-n)/(xp-xn) et le calcul du décalage négatif est effectué d'après la directive de calcul : b=(xp*n-xn*p)/(xp-xn).

15. Procédé de conversion analogique-numérique selon la revendication 3 à 12, **caractérisé en ce que**, en cas de signaux bipolaires, le calcul récursif de l'amplification inverse et du décalage négatif reposent sur une correction incrémentale, **en ce qu'**une première grandeur auxiliaire (p) et une deuxième grandeur auxiliaire (n) sont introduites, dans lequel
dans le cas où le premier signal numérique (x1) est supérieur à zéro et si le premier signal numérique (x1) est supérieur à la multiplication du deuxième signal numériques (x2) par l'amplification inverse supposée (a) et de l'addition avec le décalage négatif supposé (b) (x1>a*x2+b), la première grandeur auxiliaire (p) est mise à la valeur +1, et si le premier signal numérique (x1) est inférieur à la multiplication du deuxième signal numérique (x2) par l'amplification inverse supposée (a) et de l'addition avec le décalage négatif supposé (b) (x1>a*x2+b), la première grandeur auxiliaire (p) est mise à la valeur -1, et si le premier signal numérique (x1) est inférieur à zéro et dans le cas où le premier signal numérique (x1) est supérieur à la multiplication du deuxième signal numérique (x2) par l'amplification inverse supposée (a) et de l'addition avec le décalage négatif supposé (b) (x1>a*x2+b), la deuxième grandeur auxiliaire (n) est mise à la valeur +1, et si le premier signal numérique (x1) est inférieur à la multiplication du deuxième signal numérique (x2) avec l'amplification inverse supposée (a) et de l'addition avec le décalage négatif supposé (b) (x1>a*x2+b), la deuxième grandeur auxiliaire (n) est mise à la valeur -1, et **en ce que**, en outre dans le cas où, si la première grandeur auxiliaire (p) et la deuxième grandeur auxiliaire (n) ont la même valeur +1, le décalage négatif (b) est incrémenté, où si la première grandeur auxiliaire (p) et la deuxième grandeur auxiliaire (n) ont la même valeur -1, le décalage négatif (b) est décrémenté et les première et deuxième grandeurs auxiliaires (p) (n) sont mises à la valeur zéro, où si la première grandeur auxiliaire (p) est égale à la valeur +1 et la deuxième grandeur auxiliaire (n) est égale à la valeur -1, l'amplification inverse (a) et le décalage négatif (b) sont incrémentés et les première et deuxième grandeurs auxiliaires (p) (n) sont mises à la valeur zéro, où si la première grandeur auxiliaire (p) est égale à la valeur -1 et la deuxième grandeur auxiliaire (n) est égale à la valeur +1, l'amplification inverse (a) et le décalage négatif (b) sont décrémentés et les première et deuxième grandeurs auxiliaires (p)(n) sont mises à la valeur zéro, et **en ce que**, en outre, la décrémentation et l'incrémentation sont effectuées avec des pas suffisamment petits.

16. Procédé de conversion analogique-numérique selon la revendication 1 à 15, **caractérisé en ce que** la première limite (s1) est calculée cycliquement.

17. Procédé de conversion analogique-numérique selon la revendication 16, **caractérisé en ce que**, en cas d'un décalage négatif si petit qu'il soit négligeable, la première limite (s1) est égale à la valeur maximale de l'échelle du premier signal numérique (x1) multipliée par l'amplification inverse supposée (a) (s1=a*FS).

18. Procédé de conversion analogique-numérique selon la revendication 16, **caractérisé en ce que** la première limite (s1) est égale à la valeur maximale de l'échelle (FS) du premier signal numérique (x1) multipliée par l'amplification inverse (a) et de l'addition du décalage négatif (b) (s1 =a*FS+b).

19. Procédé de conversion analogique-numérique selon la revendication 16, **caractérisé en ce que**, en cas d'un décalage négatif si petit qu'il soit négligeable, la première limite (s1) est égale à la valeur maximale de l'échelle du premier signal numérique (x1) multipliée par l'amplification inverse supposée (a) et multipliée par une constante (c), qui est typiquement inférieure à 1 (s1=a*c*FS), ce qui évite d'éventuelles saturations internes à proximité de la première limite (s1).

20. Procédé de conversion analogique-numérique selon la revendication 16, **caractérisé en ce que** la première limite (s1) est égale à la multiplication d'une constante (c), qui est typiquement inférieure à 1, par la valeur maximale de l'échelle (FS) du premier signal numérique (x1) multipliée par l'amplification inverse (a) et de l'addition du décalage négatif (b) (s1=c*(a*FS+b)), ce qui évite d'éventuelles saturations internes à proximité de la première limite (s1).

21. Procédé de conversion analogique-numérique selon la revendication 4 à 20, **caractérisé en ce que** la deuxième limite (s2) est calculée cycliquement.

22. Procédé de conversion analogique-numérique selon la revendication 21, **caractérisé en ce que** la deuxième limite (s2) est égale à la première limite (s1) multipliée par l'amplification inverse supposée (a) (s1 =a*s2).

23. Procédé et dispositif de conversion analogique-numérique de signaux au moyen de plusieurs convertisseurs AN non à haute résolution, **caractérisés en ce que** le signal analogique, est converti une fois non amplifié en un premier signal numérique (x1) et plusieurs fois après un traitement de signal, en général une amplification entachée d'erreurs, supérieure à 1, dont les grandeurs ne doivent pas être connues avec précision, est converti en plusieurs signaux numériques (x2....xn), pour chaque paire de signaux numériques étant effectué un procédé correspondant aux revendications 1 à 22, ce qui réalise une mise en cascade.

24. Procédé et dispositif de conversion analogique-numérique de signaux selon la revendication 1 à 23, **caractérisés en ce que**, pour obtenir le premier signal numérique (x1), seulement après un traitement de signal, en général une amplification entachée d'erreurs dont les grandeurs ne doivent pas être connues avec précision, le signal analogique est également converti en un signal numérique (x1), ce qui raccourcit particulièrement les erreurs de temps de propagation.

25. Procédé de conversion analogique-numérique selon la revendication 1 à 24, **caractérisé en ce que**, après la mise sous tension, cycliquement ou selon les besoins, on applique au dispositif de conversion analogique-numérique un signal de calibration avec lequel sont déterminées les valeurs, qui sont nécessaires au fonctionnement et qui sont décrites dans les revendications 1 à 24.
